# EUROPÄISCHE PATENTANMELDUNG

(11) **EP 2 472 579 A1**
(43) Veröffentlichungstag der Anmeldung: **04.07.2012**
(21) Anmeldenummer: 11001980.9
(22) Anmeldetag: 10.03.2011
(51) Int. Cl.: H01L 27/146

(54) **Kontaktierung von Bauelementen auf Substraten**

(30) Priorität: 30.12.2010 WO PCT/EP2010/007976
(71) Anmelder: Baumer Innotec AG, 8500 Frauenfeld (CH)
(72) Erfinder: Mueller, Daniel, 8545 Rickenbach (CH); Gross, Ralf, 8280 Kreuzlingen (CH); Tiedeke, Joachim, 8280 Kreuzlingen (CH)
(74) Vertreter: Schmidt, Oliver

(57) **Zusammenfassung**

Die Erfindung betrifft ein Verfahren zur Verbindung und Kontaktierung von Bauelementen auf Trägern, umfassend eine Schaltungsanordnung, ein mit elektrischen Leiterbahnen versehenes Träger und ein elektronisches, bevorzugt optoelektronisches Bauelement, besonders bevorzugt ein optisches ASIC, wobei das Bauelement mit den elektrischen Leiterbahnen des Träger elektrisch leitend verbunden ist. Das Bauelement wird dabei rückseitig auf dem Träger montiert und mittels der Silizium-Durchkontaktierung elektrisch leitend kontaktiert, wobei die lichtempfindliche Fläche des Bauelements auf der dem Träger abgewandten Seite angeordnet ist.

## Beschreibung

Die Erfindung betrifft ein Verfahren zur Verbindung und Kontaktierung von Bauelementen auf Trägern, umfassend eine Schaltungsanordnung, ein mit elektrischen Leiterbahnen versehene Träger und ein elektronisches, bevorzugt optoelektronisches Bauelement, wobei das Bauelement mit den elektrischen Leiterbahnen des Trägermaterials elektrisch leitend verbunden ist.

In der Mikroelektronik werden zur Ausbildung von Schaltungen typischerweise Bauelemente oder Integrierte Schaltkreise (ICs), etwa elektronische oder optoelektronische Bauelemente, mit Trägermaterialien verbunden, wobei die Träger elektrischen Leiterbahnen aufweisen. Auf diese Weise können mehrere Bauelemente miteinander elektrisch leitend verbunden werden, so dass beispielsweise eine mikroelektronische Schaltungsanordnung aufgebaut werden kann.

Optoelektronische Bauelemente können beispielsweise anwendungsspezifische integrierte Schaltungen mit optischen Chip, sogenannte Optische ASICs, darstellen. Diese können beispielsweise verwendet werden als optischer Empfänger.

Typischerweise werden derartige Bauelemente zum Schutz, aus Gründen der mechanischen Stabilität sowie zur Aufnahme von elektrischen Kontaktierungspunkten mit einer Verpackung (Packaging) bzw. einem Gehäuse versehen. Zur Verpackung und Kontaktierung sind eine Vielzahl von Verfahren und Technologien bekannt.

So ist etwa bekannt, Bauelemente mit oberflächenmontierbaren Gehäusen und Kontakten zu versehen und auf eine Seite der Träger elektrisch leitend zu löten oder zu kleben (SMD-Technik). Hierzu gehören etwa die Gehäuseformen SOIC (small-outline integrated circuit), SOP (small outline package) oder SSOP (shrink small-ouline packaging).

Im Falle von optoelektronischen Bauelementen oder optischen ASICs ist es erforderlich, dass die Gehäuse optisch durchlässig bzw. durchlässig für die relevanten entsprechenden Wellenlängenbereiche sind, um den optisch aktiven bzw. strahlungsempfindlichen Teil des Bauelements der entsprechenden Strahlung auszusetzen. Soll beispielsweise der optische ASIC Licht im sichtbaren Bereich empfangen oder senden können, so ist das Gehäuse durchlässig für elektromagnetische Strahlung im Bereich von etwa 380 bis 780 Nanometer auszubilden.

So zeigt etwa die DE 10 2006 053 982 B4 eine Trägerstruktur für optoelektronische Bauelemente. Der optische ASIC ist hierbei mit einem nicht transparenten, Kunststoff vergossen, wobei der Kunststoff ein optisches Fenster aus einem transparenten Kunststoffmaterial aufweist. Zur elektrischen Kontaktierung des Bauelements sind Kontaktbeine nach außen aus dem Gehäuse herausgeführt, die mit den elektrisch leitenden Leiterbahnen des Trägers elektrisch leitend verbunden werden.

Andere bekannte Arten der Verpackungen für derartige Bauelemente stellen beispielsweise die Gehäuseformen QFN (Quad Flat No Leads) oder CSP dar (chip-size packaging). Bei der Gehäuseform QFN wird etwa ein flacher, typischerweise quadratischer Gehäusekörper verwendet, wobei die elektrischen Kontaktierungspunkte rahmenartig um das Gehäuse herum angeordnet sind und sich als metallisierte Kontaktflächen unter dem Gehäuse befinden.

Für optoelektronische Bauelemente kann anstelle des sonst häufig für das Gehäuse verwendeten Duroplastmaterials zumindest zum Teil auch ein lichtdurchlässiges Thermoplastmaterial eingesetzt werden, wie etwa in der DE 10 2007 001 706 A1 beschrieben.

Als nachteilig erweist sich bei derartig verpackten und kontaktierten Bauelementen der relativ große Flächenbedarf, der auf dem Träger benötigt wird. Der Flächenbedarf ergibt sich aus der Fläche, die für das Gehäuse sowie den nach außen geführten Kontaktbeinen oder Kontaktdrähten Bonddrähte) benötigt wird.

Zudem führt die Verpackung, insbesondere im Fall von optoelektronischen Bauelementen wie optischen ASICs, zu hohen zusätzlichen Kosten, da beispielsweise lichtdurchlässige Kunststoffen zusätzlich zu den lichtundurchlässigen Kunststoffen verwendet werden.

Eine andere Variante zur Verbindung eines elektronischen oder optoelektronischen Bauelements mit einem Trägersubstrat beschreibt die DE 10 2007 035 060 A1. Hier sind sowohl das Halbleiterbauelement als auch das Trägersubstrat mit kleinen Bohrungen versehen. So dann werden Bauelement und Träger derart angeordnet, dass die Löcher jeweils übereinander liegen und Verbindungsstifte jeweils durch die Löcher von Bauelement und Träger geführt werden können. Hiernach erfolgt eine Durchkontaktierung.

Dieses Verfahren bietet die Möglichkeit, mechanische Spannungen, die im Träger vorliegen, über die Verbindungsstifte abzubauen. Demgegenüber steht allerdings ein deutlich erhöhter Aufwand in der Herstellung der Kontaktierung, da einerseits die Bohrungen eingebracht werden müssen, andererseits nach dem Aufsetzen auch noch eine Verstiftung durchgeführt werden muß, wobei hier sehr hohe Genauigkeitsanforderungen zu erfüllen sind.

Die Aufgabe der vorliegenden Erfindung besteht also darin, eine Möglichkeit der Verbindung und Kontaktierung von elektronischen, bevorzugt optoelektronischen Bauelementen auf Trägermaterialien zu schaffen, die im Vergleich zu den bekannten Verfahren deutlich platzsparender und kostengünstiger zu realisieren ist.

Dabei ist ein Ziel der Erfindung, die auf dem Träger benötigte Fläche auf ein Minimum zu reduzieren. Bevorzugt sollen optoelektronische Bauelemente und besonders bevorzugt optische ASICs mit dem Träger verbunden und kontaktiert werden.

Als Trägermaterialien können dabei beispielsweise Leiterplatten, Folienleiterplatten, keramische oder metallische Platten mit elektrischen Leiterbahnen oder auch Platten aus Glas eingesetzt werden.

Die Aufgabe wird auf überraschend einfache Weise durch die Verwendung der sogenannten Flip-Chip-Technologie in Verbindung mit der Silizium-Durchkontaktierung ("Through-Silicon-Via"-Technologie) gelöst.

Die Flip-Chip-Technologie ist ein Verfahren, bei dem das Bauelement umgedreht wird und sodann direkt mit der Kontaktierungsseite zum Träger hin montiert und kontaktiert wird. Hierbei ist das Bauelement nicht eingehaust, d.h. insbesondere die strahlungsempfindliche Fläche des Bauelements liegt frei. Desweiteren werden im allgemeinen keinerlei Kontaktdrähte oder Kontaktbeine verwendet, da die elektrische Kontaktierung über Kontaktierhügel, den sogenannten Bumps oder Balls, erfolgt.

Die Nutzung der Flip-Chip-Technologie für optische ASICs bietet verschiedene Vorteile. So führt sie zu besonders geringen Abmessungen des Bauelements, wodurch die auf dem Träger benötigte Fläche auf ein Minimum reduziert werden kann.

Sodann sind die Leiterlängen sehr kurz im Vergleich zu elektrischen Verbindungen mittels Kontaktbeinen oder Kontaktdrähten. Dieses führt letztendlich zu einer höheren Geschwindigkeit der Signalübertragung und damit zu einer höheren Performance der Schaltungsanordnung.

Desweiteren ermöglicht die Flip-Chip-Technologie die Aufnahme mehrerer Kontaktierungspunkte im Vergleich etwa zu einer SSOP-Verpackung, da die zur Verfügung stehende Fläche größer ist. Bei der Flip-Chip-Technologie kann die gesamte, flächige Seite des Chips zur Herstellung der Kontaktierungspunkte genutzt werden.

Im Sinne der Erfindung wird das Bauelement, bevorzugt das optoelektronische Bauelemente und besonders bevorzugt das optische ASIC, herumgedreht und über die Rückseite montiert. Unter Rückseite des Bauelements ist diejenige Seite zu verstehen, die der strahlungsempfindlichen Seite des Bauelements gegenüberliegt.

Die Kontaktierung mit dem Träger erfolgt mittels der Silizium-Durchkontaktierung. Hierunter ist eine vertikale elektrische Verbindung aus Metall durch ein Silizium-Träger zu verstehen. Die elektrische Kontaktierung zu dem Träger erfolgt mittels Balls oder Bumps. Bei diesem Kontaktierungsverfahren kann auf Kontaktbeine oder Kontaktdrähte vollständig verzichtet werden. Ebenso ist eine Verpackung oder Einhausung oder ein Umgeben des Bauelements mit einem Gehäuse nicht erforderlich, so dass das Bauelement ungehaust ist.

Auf diese Weise gelingt es, Bauelemente, bevorzugt optoelektronische Bauelemente und besonders bevorzugt optische ASICs, ungehaust direkt dergestalt mit dem Träger zu verbinden, dass die dem Träger abgewandte flächige Seite des Bauelements den strahlungsempfindlichen Teil oder die strahlungsempfindliche Fläche des Bauelements enthält.

Aus dieser überraschend einfachen Anordnung ergeben sich im Sinne der vorliegenden Erfindung eine Reihe von Vorteilen. So kann die gesamte Fläche des optischen ASICs für die Ausbildung der Kontaktierungspunkte genutzt werden. Insbesondere bei hochintegrierten Bauelementen ist häufig eine Vielzahl von elektrischen Kontakten herzustellen, die nicht immer auf dem Umfang eines Gehäuses unterzubringen sind.

Bei Verwendung der Flip-Chip-Technologie können diese Kontaktierungspunkte schach- oder gitterbrettartig angebracht werden, wie sie beispielsweise aus den als LGA (land grid array) oder als BGA (ball grid array) bekannten Kontaktierungsverfahren geläufig sind.

Die auf dem Träger durch das montierte Bauelement belegte Fläche ist durch die erfindungsgemäße Art der Anordnung und Kontaktierung auf ein Minimum beschränkt. So wird nur eine Seite des Trägers für die Aufnahme des Bauelements benötigt, wobei sich der benötigte Flächenbedarf auf näherungsweise die Größe des Bauelements beschränkt.

Durch den Verzicht auf die Verpackung ist zudem die Herstellung der Bauelemente einfacher zu realisieren.

In einer weiteren Ausführungsform kann das optoelektronische Bauelement mit einer Moldmasse umgeben sein, um die mechanische Stabilität zu erhöhen sowie die Kontaktierungsbereiche zwischen dem Bauelement und dem Träger zu schützen.

In einer weiteren besonderen Ausführungsform kann das optoelektronische Bauelement auch auf ein weiteres Bauelement aufgesetzt werden, wodurch sich eine gestapelte Anordnung ergibt. Zwischen dem optoelektronischen Bauelement und dem zumindest einen weiteren Bauelement kann dabei eine Zwischenschicht angeordnet sein. Auf diese Weise lassen sich mehrere Bauelemente übereinander stapeln, wobei vorzugsweise das von dem Träger am weitesten entfernte Bauelement das bevorzugt optoelektronische Bauelement sein sollte.

Die Schaltungsanordnung, bestehend aus dem Bauelement, bevorzugt optoelektronischen Bauelement und dem Substrat, welches elektrisch leitend mit dem Bauelement verbunden ist, kann beispielsweise in einer mikroelektronischen Baugruppe eingesetzt werden.

Diese mikroelektronische Baugruppe kann somit Bestandteil einer optischen Vorrichtung zum Übertragen, zum Senden und/oder zum Empfangen von optischen Signalen sein. Aufgrund der erfindungsgemäßen Schaltungsanordnung kann die mikroelektronische Baugruppe sehr kompakt und klein gebaut sein, so dass sich die optische Vorrichtung durch besonders kleine Abmessungen auszeichnet.

Beispielsweise kann diese optische Vorrichtung als Sender oder Empfänger von Licht im sichtbaren Bereich eingesetzt werden, wenn der optische ASIC eine Strahlungsempfindlichkeit in einem Wellenlängenbereich von etwa 380 bis 780 Nanometern aufweist. Ebenso kann die optische Vorrichtung auch als Sender und/oder Empfänger elektromagnetischer Strahlung in anderen Wellenlängenbereichen ausgebildet sein.

In einer bevorzugten Anordnung wird die erfindungsgemäße optische Vorrichtung zur berührungslosen Messung von Entfernungen mittels optischer Triangulation eingesetzt. Hierbei werden über eine elektronische Distanzmessung die Längen einzelner Dreiecksseiten eines Dreiecksnetzes ermittelt, wobei die Ecken des Dreiecks die sogenannten trigonometrischen Punkte darstellen.

Desweiteren kann die erfindungsgemäße optische Vorrichtung eingesetzt werden, um beispielsweise optische Informationen mit weiteren Vorrichtungen zu optischen Signalübertragung auszutauschen. So können etwa an die optische Vorrichtung Lichtwellenleiter oder Glasfasern angekoppelt werden.

Zudem kann die erfindungsgemäße optische Vorrichtung in Vorrichtungen zum Messen und Identifizieren von biometrischen Merkmalen eingesetzt werden. Diese Merkmale können etwa Fingerabdrücke, Iris oder auch Retina sein.

Weitere Vorteile der Erfindung ergeben sich aus der folgenden Beschreibung von Ausführungsbeispielen anhand der Figuren.

Die Figur 1 zeigt eine erfindungsgemäße Ausführungsform der Verbindung zwischen Bauelement und Träger im Querschnitt.

Figur 2 zeigt eine Ausführungsvariante, bei der zusätzlich eine Moldmasse zur Befestigung aufgebracht ist.

In Figur 3 ist eine weitere Ausführungsvariante dargestellt, bei der der optische ASIC mit einer Deckschicht versehen ist und zudem eine Schicht zwischen der Moldmasse sowie dem Träger angebracht ist.

Figur 4 zeigt eine Möglichkeit, mehrere Bauelemente, darunter zumindest ein optoelektronisches Bauelement, besonders bevorzugt ein optisches ASIC, mit weiteren Bauelementen zu stapeln

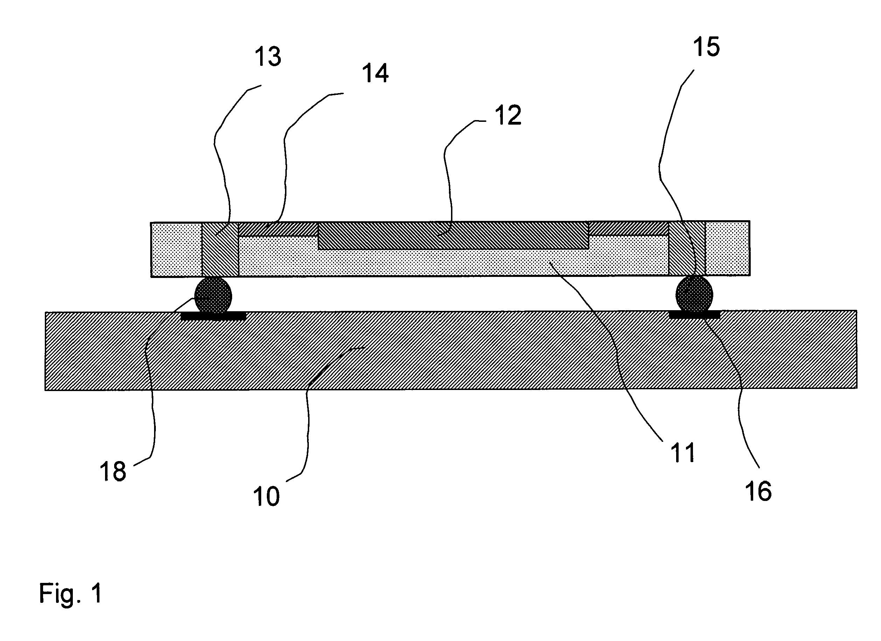

In Figur 1 ist ein Träger (10) mit elektrischen Kontaktflächen bzw. Leiterbahnen (16) dargestellt. Ein optisches ASIC (11) weist eine strahlungsempfindliche Oberfläche (12) auf, die auf der dem Träger entgegengesetzten Seite angeordnet ist. Diese strahlungsemfindliche Oberfläche kann dabei einen Teil der Außenoberfläche oder auch die gesamte Außenoberfläche des Bauelements darstellen. Erfindungsgemäß liegt diese Fläche frei.

Über Balls (15, 18) ist der optische ASIC elektrisch leitend mit den elektrischen Leiterbahnen (16) des Trägers (10) verbunden. Über den Balls ist schematisch die Silizium-Durchkontaktierung dargestellt (13). (14) stellt schematisch eine Leiterbahn des ASICs dar.

In der Figur 1 sind der Übersichtlichkeit halber nur zwei Kontaktierungspunkte (16, 18) dargestellt. Im Sinne der Erfindung können die Kontaktierungspunkte auch linienförmig, gitter- oder schachbrettartig angeordnet sein. Derartige Anordnungen für Kontaktierungspunkte sind beispielsweise von den Verbindungssystemen LGA (Land Grid Array) oder BGA (Ball Grid Array) bekannt.

In einer besonderen Ausführungsform der Erfindung werden die Seiten des Bauelements zusätzlich mit einer Moldmasse umgeben. Hierdurch wird die mechanische Stabilität erhöht. Zudem können auf diese Weise die elektrischen Kontaktflächen geschützt werden vor äußeren Einflüssen. Die Moldmasse kann dabei beispielsweise die Materialien SiO₂ und/oder Epoxydharz umfassen.

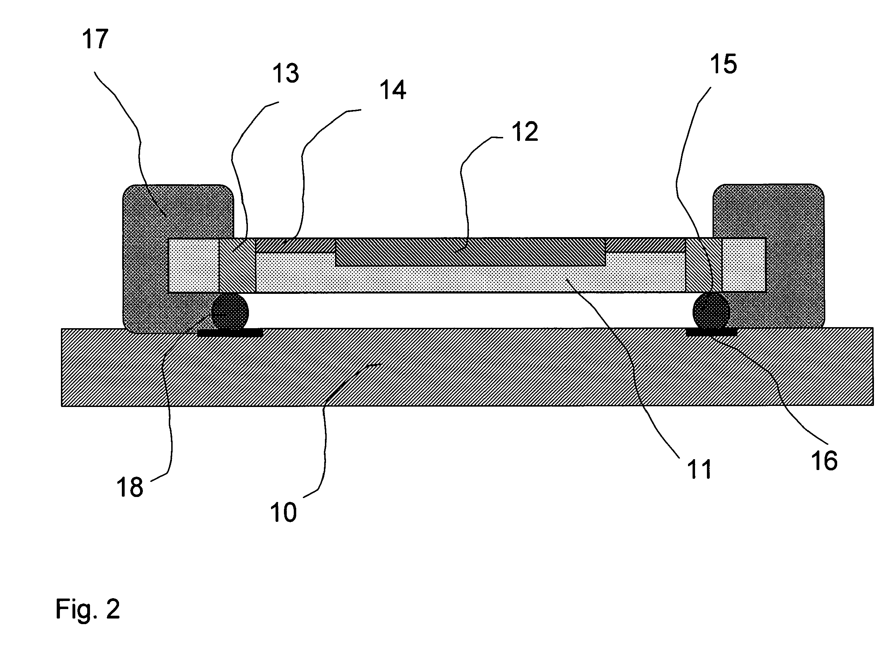

Figur 2 zeigt einen derartigen Aufbau mit einer Moldmasse (17). Die Moldmasse kann dabei das Bauelement an seinen Seitenflächen umschliessen. Sie kann zusätzlich mit dem Träger über ein elektrisch nicht leitenden Kleber verbunden werden.

In einer weiteren besonderen Ausführungsform wird zwischen der Moldmasse und dem Träger eine Verbindungsschicht angeordnet. Diese kann beispielsweise ein elektrisch nicht leitender Klebstoff oder ein Lack sein.

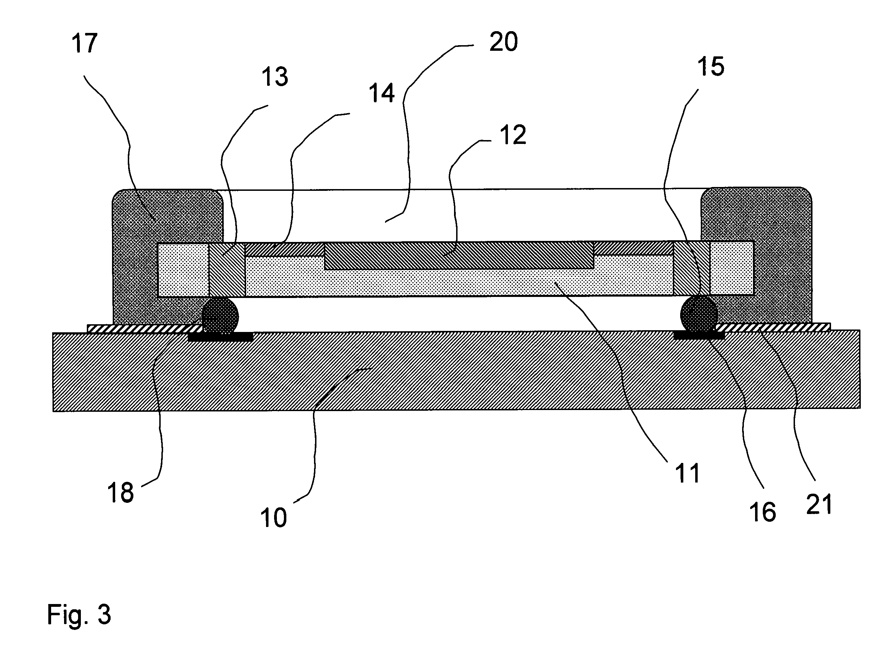

Hierdurch kann eine bessere thermische und/oder mechanische Entkopplung von Bauelement und Träger erzielt werden. In Figur 3 ist eine derartige Verbindungsschicht (21) abgebildet.

In einer Weiterentwicklung der Erfindung wird auf der dem Träger abgewandten Seite des Bauelements, auf der die strahlungsempfindliche Oberfläche des ASIC liegt, ein zusätzliches Material zum Erzielen bestimmter Wirkungen angeordnet.

In Figur 3 ist ein derartiges Material (20) gezeigt. Das Material ist zumindest für diejenigen Wellenlängenbereiche, in denen der optische ASIC arbeitet, transparent auszubilden, wobei dieses zumindest für den Bereich der strahlungsempfindlichen Oberfläche gilt.

Das Material kann beispielsweise ein transparentes Glas oder eine Glasfaseroptik sein, um die Oberfläche des Bauelements vor äußeren Einflüssen wie etwa Abrasion oder Witterung zu schützen.

Ebenso kann es sich auch um eine Schutzfolie, etwa eine transparente oder antireflektierende Schutzfolie handeln. Derartige Schutzfolien sind beispielsweise von Displayschutzfolien her bekannt.

Desweiteren kann es sich bei dem Material auch um eine dünne Schicht oder um Dünnschichten handeln. Die dünne Schicht kann beispielsweise aus Silikon, Lack oder Gießharz hergestellt sein. Dünnschichten können etwa über einen Kathodenzerstäubungsprozeß aufgebracht werden.

Durch diese Schichten können weitere bestimmte Wirkungen erzielt werden, etwa das Versehen der Oberfläche des Bauelements mit einer Verschleiß- oder Kratzschutzschicht oder auch das Erzeugen eines schmutzabweisenden Effekts der Oberfläche. Zudem können bestimmte Farbeffekte bewirkt werden.

Durch dielektrische dünne Schichten kann zudem auch die Interferenz von Licht genutzt werden. So kann beispielsweise ein bestimmter Reflexionsgrad in Abhängigkeit von einem Wellenlängenbereich durch die dünne Schicht eingestellt werden.

In einer weiteren besonderen Ausführungsform wird die Schaltungsanordnung, umfassend zumindest das Bauelement, bevorzugt das optoelektronische Bauelement und besonders bevorzugt das optische ASIC, auf zumindest ein weiteres Bauelement aufgesetzt, wobei zwischen dem zumindest weiteren Bauelement und dem Träger des optischen ASIC eine Zwischenschicht angeordnet ist.

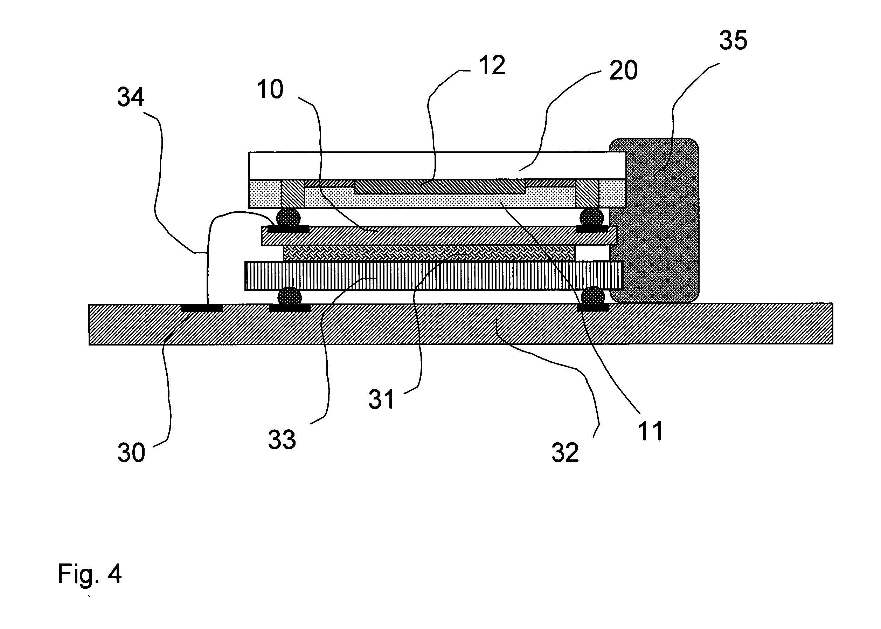

Figur 4 zeigt eine derartige Konfiguration. Das Trägermaterial (10), welches mit dem optischen ASIC (11) verbunden ist, ist über eine Zwischenschicht (31) mit einem weiteren Bauelement (33), welches ein Halbleiterbauelement darstellen kann, verbunden. Dieses weitere Bauelement ist ebenfalls elektrisch leitend mit einem weiteren Träger (32) verbunden, beispielsweise ebenfalls über Balls oder Bumps, die wiederum mit den elektrischen Leiterbahnen (30) des weiteren Trägers verbunden sind.

Zusätzlich ist der Träger (10) mit dem Träger (32) elektrisch leitend verbunden, wobei diese elektrische Verbindung beispielsweise über Drahtschleifen (34) hergestellt werden kann. In der Figur ist der Übersichtlichkeit halber nur eine Drahtschleife abgebildet.

Dabei kann das optische ASIC weiterhin mit einem Material oder mit einer Schicht (20) versehen sein. Auf diese Weise können mehrere Bauelemente, beispielsweise ein Bauelement mit bevorzugt einer strahlungsempfindlichen Fläche zusammen mit einem weiteren Bauelement, welches keine derartige Oberflächen aufweist, gestapelt werden. Diese gestapelte Bauweise führt zu einer nochmals verbesserten Flächennutzung auf dem Träger.

Zur Verbesserung der mechanischen Stabilität des Stapels kann weiterhin eine Moldmasse (35) eingebracht werden, die die verbundenen Bauelemente und/oder der Träger und/oder die Zwischenschicht verbindet und die Bauelemente umgibt. Der Übersichtlichkeit halber ist in der Figur nur auf einer Seite eine Moldmasse abgebildet.

## Patentansprüche

1. Schaltungsanordnung, umfassend ein Träger mit elektrischen Leiterbahnen und zumindest ein Halbleiterbauelement, bevorzugt ein optoelektronisches Bauelement und besonders bevorzugt ein optisches ASIC, welches elektrisch leitend mit den elektrischen Leiterbahnen des Trägers verbunden ist, **dadurch gekennzeichnet, dass** das Halbleiterbauelement eine strahlungsempfindliche Fläche aufweist, die auf der dem Träger abgewandten Seite liegt, dass das Bauelement ungehaust ausgebildet ist und dass das Bauelement mittels einer Silizium-Durchkontaktierung direkt mit dem Träger verbunden ist, wobei die lichtempfindliche Fläche freiliegt.

2. Schaltungsanordnung nach Anspruch 1, **dadurch gekennzeichnet, dass** der Träger elektrische Leiterbahnen aufweist, die beispielsweise auf Leiterplatten, Folienleiterplatten, Metallplatten, Glasplatten oder Keramikplatten aufgebracht sind.

3. Schaltungsanordnung nach vorstehenden Ansprüchen, **dadurch gekennzeichnet, dass** das Bauelement mit dem Träger über Balls oder Bumps elektrisch leitend verbunden ist.

4. Schaltungsanordnung nach vorstehenden Ansprüchen, **dadurch gekennzeichnet, dass** zur Herstellung der elektrische leitenden Verbindung ein Lot oder ein elektrisch leitender Klebstoff eingesetzt wird.

5. Schaltungsanordnung nach vorstehenden Ansprüchen, **dadurch gekennzeichnet, dass** das Bauelement, bevorzugt das optoelektronische Bauelement und besonders bevorzugt das optische ASIC rückseitig (Flip-Chip-Technologie) kontaktiert wird.

6. Schaltungsanordnung nach vorstehenden Ansprüchen, **dadurch gekennzeichnet, dass** das Bauelement von einer Moldmasse umgeben wird.

7. Schaltungsanordnung nach vorstehenden Ansprüchen, **dadurch gekennzeichnet, dass** das Bauelement an seiner lichtempfindlichen Seite zusätzlich ein lichtsdurchlässiges Material enthält, umfassend ein Glas, eine Glasfaseroptik, eine Schutzfolie, eine Schicht oder eine Dünnschicht.

8. Schaltungsanordnung nach vorstehenden Ansprüchen, **dadurch gekennzeichnet, dass** das optoelektronische Bauelement, besonders bevorzugt das optische ASIC, auf ein weiteres Bauelement gestapelt wird, wobei zwischen den Bauelementen ein zusätzliches Material als Zwischenschicht angeordnet ist.

9. Schaltungsanordnung nach Anspruch 8, **dadurch gekennzeichnet, dass** die gestapelten Bauelemente elektrisch mit zumindest einem gemeinsamen Träger verbunden sind.

10. Schaltungsanordnung nach Anspruch 8 und 9, **dadurch gekennzeichnet, dass** eine Moldmasse die gestapelten Bauelemente umgibt.

11. Mikroelektronische Baugruppe, umfassend zumindest ein Halbleiterbauelement, bevorzugt ein optoelektronisches Bauelement und besonders bevorzugt ein optisches ASIC, welches elektrisch leitend mit dem elektrisch leitenden Teil eines Trägers verbunden ist, **dadurch gekennzeichnet, daß** die Baugruppe eine Schaltungsanordnung nach den Ansprüchen 1 bis 10 enthält.

12. Mikroelektronische Baugruppe nach Anspruch 11, **dadurch gekennzeichnet, dass** der optische ASIC als Sender oder Empfänger optischer Signale in einem Wellenlängenbereich von etwa 350 bis 780 Nanometer arbeitet.

13. Optische Vorrichtung zum Übertragen, zum Senden und/oder zum Empfangen optischer Signale, umfassend zumindest eine mikroelektronische Baugruppe nach Anspruch 11 und 12.

14. Optische Vorrichtung nach Anspruch 13, umfassend eine optische Anordnung zur berührungslosen Messung von Entfernungen mittels optischer Triangulation, wobei als Lichtsensor die mikroelektronische Baugruppe nach Anspruch 11 und 12 eingesetzt wird.

15. Optische Vorrichtung nach Anspruch 15, umfassend zumindest eine mikroelektronische Baugruppe nach Anspruch 11 und 12, zur Ankopplung einer weiteren optischen Vorrichtung zur Signalübertragung über größere Strecken, wobei die weitere Vorrichtung ein Lichtwellenleiter oder eine Glasfaser oder ein Glasfaserkabel sein kann.

16. Optische Vorrichtung, umfassend zumindest eine mikroelektronische Baugruppe nach Anspruch 11 und 12, zur Messung und Identifizierung biometrischer Merkmale wie Fingerabdrücke, Iris oder Retina.
